# DEMANDE DE BREVET EUROPEEN

(11) **EP 4 672 609 A2**
(43) Date de publication de la demande: **31.12.2025**
(21) Numéro de dépôt: 25185260.4
(22) Date de dépôt: 25.06.2025
(51) Int. Cl.: H03K 17/687, H01H 9/54, H02H 9/02, H03K 17/22, H02H 3/087, H03K 17/082

(54) **DISPOSITIF DE COMMUTATION ÉLECTRIQUE À SEMI-CONDUCTEURS**

(30) Priorité: 26.06.2024 FR 2406864
(71) Demandeur: SCHNEIDER ELECTRIC INDUSTRIES SAS, 92500 Rueil-Malmaison (FR)
(72) Inventeur: BRENGUIER, Jérôme, 92500 Rueil Malmaison (FR)
(74) Mandataire: Lavoix

(57) **Abrégé**

Ce dispositif (2) de commutation, configuré pour être connecté entre une source d'énergie électrique (4) et une charge (6), comporte
- un interrupteur principal (16) ;
-au moins un transistor à effet de champ de type JFET (18), connecté entre la source (4) et l'interrupteur principal (16), comportant deux électrodes principales (D, S) et une électrode de commande (G), et adapté pour basculer, sur commande de tension sur ladite électrode de commande (G), entre un état passant et un état bloqué ;
-un module de contrôle (24), configuré pour commander ledit au moins un transistor (18) ; - un circuit de protection au démarrage (26), connecté audit au moins un transistor, configuré pour commander un basculement du au moins un transistor (18) à l'état bloqué, comportant un composant inductif, et adapté pour générer une tension de commande du transistor lorsqu'une variation de courant traverse ledit bloc de protection.

## Description

La présente invention concerne un dispositif de commutation électrique à semi-conducteurs.

On connaît divers types de dispositifs de commutation électrique à semi-conducteurs, également appelés disjoncteurs à semi-conducteurs ou disjoncteurs SSCB (de l'anglais « Solid State Circuit Breakers »). De tels dispositifs de commutation électrique comprennent un ou plusieurs transistors, selon qu'il s'agit de dispositifs de commutation monodirectionnels ou bidirectionnels en courant.

Un dispositif de commutation électrique est configuré pour être connecté entre une source et une charge, et comporte un interrupteur principal (ou sectionneur) configuré pour basculer dans une configuration d'ouverture dans laquelle la source et la charge sont isolées galvaniquement l'une de l'autre, et dans une configuration de fermeture, dans laquelle la source et la charge sont connectées l'une à l'autre ; un ou plusieurs commutateurs à semi-conducteur (e.g. transistors) connectés entre la source et l'interrupteur et susceptibles de basculer sur commande soit à l'état passant, soit à l'état bloqué. Le dispositif de commutation électrique comprend en outre un module de contrôle, configuré pour réaliser la fonction de coupure de sécurité (ou disjonction) en cas de détection d'un défaut électrique, par exemple d'un courant d'une intensité supérieure à un seuil de courant de défaut, le module de contrôle étant configuré pour commander le ou les commutateur(s) à semi-conducteur à l'état bloqué ou à l'état passant. Ainsi, un tel dispositif de commutation électrique permet d'autoriser le passage d'un courant électrique entre la source et la charge en l'absence de défaut, et d'empêcher le passage de courant sur commande ou en cas de détection d'un défaut électrique.

On connaît notamment des dispositifs de commutation électrique comprenant un ou plusieurs transistors à effet de champ de type MOSFET (pour Metal Oxide Semiconductor Field Effect Transistor), qui sont des transistors à effet de champ à grille isolée. Cependant, les transistors MOSFET sont relativement coûteux et fragiles.

Les transistors à effet de champ à jonction ou JFET (pour « Junction Field Effect Transistor ») sont moins coûteux que les transistors MOSFET et présentent moins de pertes de conduction à aire active équivalente, notamment pour une tension jusqu'à 1,2kV.

De manière connue, un transistor de type JFET comporte trois électrodes : une électrode de commande, également appelée grille, classiquement notée G, et deux électrodes principales classiquement appelées drain (notée D) et source (notée S). Un transistor JFET est passant à l'état de repos ou passant par défaut, c'est-à-dire lorsqu'une tension sensiblement égale à zéro est appliquée sur son électrode de commande. Ainsi, si un tel transistor est utilisé dans un dispositif de commutation, un courant électrique est susceptible de circuler dans le transistor dès la fermeture de l'interrupteur principal, même en présence d'un défaut électrique dans l'installation électrique comprenant la source et la charge entre lesquels le dispositif de commutation électrique est connecté. Ce problème est plus particulièrement présent dans le cas où la source de courant électrique est un réseau de distribution électrique. En cas de présence d'un défaut électrique, par exemple d'un court-circuit en aval, le transistor JFET risque d'être endommagé par le passage d'un courant d'intensité non prévue (sur-intensité) avant que le module de contrôle détecte la présence de défaut électrique et commande l'ouverture du transistor JFET.

Le même problème se pose pour tout dispositif de commutation comportant des composants passants par défaut.

La présente invention a pour objet de remédier aux inconvénients de l'état de la technique, en proposant un dispositif de commutation électrique à semi-conducteurs de type JFET avec une protection vis-à-vis du risque d'endommagement explicité ci-dessus.

A cet effet, l'invention a pour objet un dispositif de commutation électrique à semi-conducteurs, configuré pour être connecté entre une source d'énergie électrique et une charge, comportant un interrupteur principal configuré pour basculer dans une configuration d'ouverture dans laquelle la source et la charge sont isolées l'une de l'autre, et dans une configuration de fermeture, dans laquelle la source et la charge sont connectées l'une à l'autre,
- au moins un transistor à effet de champ de type JFET, connecté entre la source et l'interrupteur principal, comportant deux électrodes principales et une électrode de commande, et adapté pour basculer, sur commande de tension sur ladite électrode de commande, entre un état passant et un état bloqué et vice versa,
- un module de contrôle, connecté entre la source et la charge, configuré pour commander ledit au moins un transistor, par application d'une tension de commande sur l'électrode de commande du transistor.

Ce dispositif de commutation comporte en outre un circuit de protection au démarrage, connecté audit au un moins transistor, le circuit de protection au démarrage étant configuré pour commander un basculement du au moins un transistor à l'état bloqué, le circuit de protection au démarrage comportant un premier bloc de protection comportant un composant inductif, le premier bloc de protection étant adapté pour générer une tension de commande lorsqu'une variation de courant traverse ledit bloc de protection, la tension de commande étant appliquée à l'électrode de commande dudit au moins un transistor.

Avantageusement, le circuit de protection au démarrage est configuré pour commander un basculement du ou de chaque transistor à l'état bloqué, par application de la tension de commande à l'électrode de commande de chaque transistor, suite à une mise en conduction électrique du dispositif de commutation, de manière à éviter tout endommagement du ou des transistors. Avantageusement, le basculement du transistor à l'état bloqué est effectué avant que l'intensité traversant le dispositif ne puisse dépasser une valeur prédéterminée, et en particulier ne dépasse l'intensité maximale supportée par le transistor.

Suivant d'autres aspects avantageux de l'invention, le dispositif de commutation électrique à semi-conducteurs comprend une ou plusieurs des caractéristiques suivantes, prises isolément ou suivant toutes les combinaisons techniquement possibles.

Le premier bloc de protection comporte, pour un transistor à effet de champ de type JFET, un composant capacitif connecté entre un premier point de connexion du composant inductif et l'électrode de commande dudit transistor, le premier point de connexion du composant inductif étant connecté à une électrode principale dudit transistor, et une diode connectée entre un deuxième point de connexion du composant inductif et l'électrode de commande du transistor, la diode étant configurée pour bloquer un courant passant dudit deuxième point de connexion du composant inductif vers l'électrode de commande dudit transistor.

Le dispositif comportant un premier et un deuxième transistor à effet de champ de type JFET, le premier bloc de protection comporte un premier composant capacitif connecté entre un premier point de connexion du composant inductif et l'électrode de commande dudit premier transistor, le premier point de connexion du composant inductif étant connecté à une électrode principale dudit premier transistor, et une diode connectée entre un deuxième point de connexion du composant inductif et l'électrode de commande du premier transistor, et comporte un deuxième composant capacitif connecté entre le deuxième point de connexion du composant inductif et l'électrode de commande dudit deuxième transistor, le deuxième point de connexion du composant inductif étant connecté à une électrode principale dudit deuxième transistor, et une diode connectée entre le premier point de connexion du composant inductif et l'électrode de commande du deuxième transistor.

Le composant inductif est une bobine d'inductance choisie.

Le composant inductif est un transformateur, comportant un enroulement primaire et un enroulement secondaire, l'enroulement primaire dudit transformateur étant connecté à une électrode principale d'au moins un desdits transistors, l'enroulement secondaire étant connecté à ladite diode du premier bloc de protection, l'enroulement primaire comportant un premier nombre de spires, l'enroulement secondaire comportant un second nombre de spires, le premier nombre de spires étant inférieur au second nombre de spires.

Le circuit de protection au démarrage comporte, pour au moins un transistor à effet de champ de type JFET, un deuxième bloc de protection, connecté entre une électrode principale dudit transistor et l'électrode de commande dudit transistor.

Le dispositif comporte en outre, pour au moins un transistor à effet de champ de type JFET, un troisième bloc de protection associé, ledit troisième bloc de protection étant un convertisseur de tension configuré pour convertir une tension continue négative d'entrée en une tension continue négative de sortie, la tension continue négative de sortie ayant une valeur absolue supérieure à une valeur absolue de la tension négative continue d'entrée, ledit convertisseur de tension étant connecté entre ladite électrode principale et l'électrode de commande dudit transistor, ladite tension négative de sortie étant appliqué sur l'électrode de commande dudit transistor.

Le convertisseur de tension est un convertisseur ZETA.

Le dispositif comporte en outre un circuit de séparation, configuré pour mettre en fonctionnement le circuit de protection au démarrage, pendant une durée de démarrage, de manière à permettre la commande dudit au moins un transistor à effet de champ de type JFET par le circuit de protection au démarrage pendant une durée de démarrage, puis une commande dudit au moins un transistor à effet de champ de type JFET par le module de contrôle après ladite durée de démarrage.

Le circuit de séparation comporte un condensateur de séparation connecté entre une alimentation auxiliaire dudit module de contrôle et le circuit de contrôle au démarrage.

Le composant capacitif du premier bloc de protection du circuit de protection au démarrage est un transformateur comportant un premier et un deuxième enroulement de spires, ledit circuit de séparation comporte un pont de commutateurs et un troisième enroulement de spires ajouté audit transformateur, le troisième enroulement de spires étant connecté entre des points milieu du pont de commutateurs.:
L'invention apparaîtra plus clairement à la lecture de la description qui va suivre, donnée uniquement à titre d'exemple non limitatif, et faite en référence aux dessins dans lesquels :
[Fig. 1] la figure 1 est un schéma électrique simplifié d'un circuit électrique comportant un dispositif de commutation électrique monodirectionnel selon un mode de réalisation ;
[Fig 2] la figure 2 est un schéma électrique d'un circuit de protection au démarrage pour dispositif de commutation monodirectionnel selon un premier mode de réalisation ;
[Fig 3] la figure 3 est un schéma d'un circuit de protection au démarrage pour dispositif de commutation monodirectionnel selon un deuxième mode de réalisation ;
[Fig 4] la figure 4 est un schéma électrique d'un circuit de protection au démarrage pour dispositif de commutation monodirectionnel selon une variante ;
[Fig 5] la figure 5 est un schéma électrique d'une partie d'un dispositif de commutation électrique monodirectionnel avec circuit de protection au démarrage et circuit de séparation selon un mode de réalisation ;
[Fig 6] la figure 6 est un schéma électrique d'une partie d'un dispositif de commutation électrique monodirectionnel avec circuit de protection au démarrage et circuit de séparation selon un autre mode de réalisation ;
[Fig 7] la figure 7 est un schéma électrique d'une partie d'un dispositif de commutation électrique bidirectionnel à deux transistors JFET selon un premier mode de réalisation ;
[Fig 8] la figure 8 est un schéma électrique d'une partie d'un dispositif de commutation électrique bidirectionnel à deux transistors JFET selon un deuxième mode de réalisation ;
[Fig 9] la figure 9 est un schéma électrique d'une partie d'un dispositif de commutation électrique bidirectionnel à deux transistors JFET selon un troisième mode de réalisation ;
[Fig 10] la figure 10 est un schéma électrique d'un circuit de protection au démarrage pour dispositif de commutation bidirectionnel selon un quatrième mode de réalisation ;
[Fig 11] la figure 11 est un schéma électrique d'un circuit de protection au démarrage pour dispositif de commutation bidirectionnel selon un cinquième mode de réalisation,
[Fig 12] la figure 12 est un schéma électrique d'un circuit de protection au démarrage pour dispositif de commutation bidirectionnel selon un sixième mode de réalisation ;
[Fig 13] la figure 13 est un schéma électrique d'une partie d'un dispositif de commutation électrique bidirectionnel avec circuit de protection au démarrage et circuit de séparation selon un mode de réalisation.

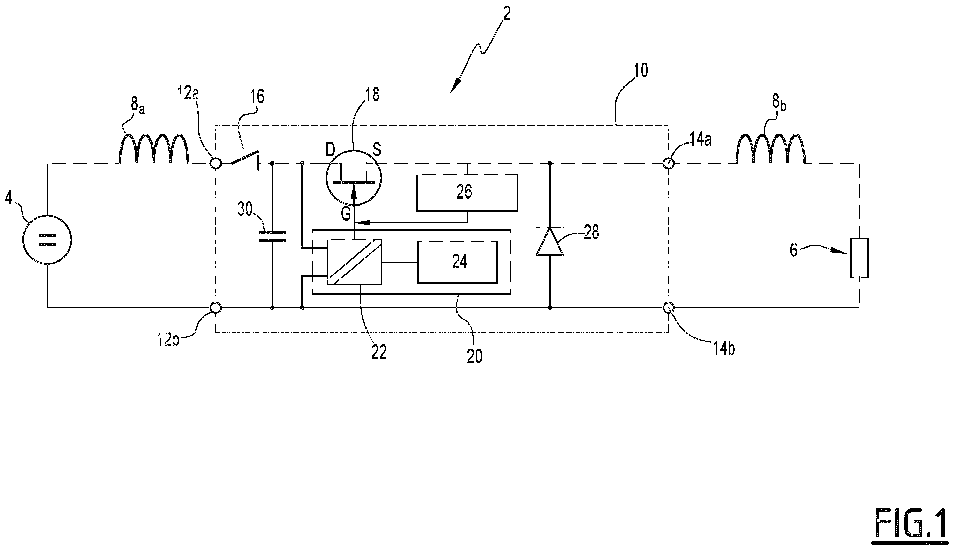

La figure 1 illustre schématiquement un circuit électrique 2 comportant une source électrique 4, appelée simplement source par la suite, de courant continu, et une charge 6.

Entre la source 4 et la charge 6 est connecté un dispositif de commutation électrique 10 à semi-conducteur, appelé simplement dispositif de commutation par la suite.

Le circuit 2 comporte des inductances de ligne 8a, 8b, en amont et en aval du dispositif de commutation électrique 10.

Le dispositif de commutation électrique 10 est connecté entre deux bornes d'entrée 12a, 12b et deux bornes de sortie 14a, 14b.

Le dispositif de commutation électrique 10 comporte un interrupteur principal 16 (ou sectionneur), configuré pour basculer dans une configuration d'ouverture dans laquelle la source 4 et la charge 6 sont isolées galvaniquement l'une de l'autre, et dans une configuration de fermeture, dans laquelle la source 4 et la charge sont connectées l'une à l'autre 6.

Dans l'exemple de la figure 1 le dispositif de commutation électrique 10 est un dispositif de commutation monodirectionnel, adapté dans ce cas de figure, la source électrique 4 étant une source à courant continu, comportant un commutateur à semi-conducteurs 18, qui est un transistor de type JFET, comportant trois électrodes, respectivement une électrode de commande (ou grille) G, et deux électrodes principales, respectivement une première électrode principale ou source S et une deuxième électrode principale ou drain D.

Dans le mode de réalisation illustré, l'interrupteur principal 16 est connecté en amont par rapport au commutateur à semi-conducteurs 18.

L'interrupteur principal 16 est connecté entre la source 4 et le drain du transistor 18.

Le dispositif de commutation électrique 10 comporte en outre un circuit de contrôle 20, comportant une alimentation électrique 22 (ou alimentation électrique auxiliaire) et un module de contrôle 24. Le module de contrôle 24 est configuré, de manière connue, pour détecter la survenue d'un défaut électrique. Le circuit de contrôle est configuré pour commander le transistor par application d'une tension de commande sur l'électrode de commande du transistor après une durée de démarrage du module de contrôle 24.

Avantageusement, le dispositif de commutation 10 comporte en plus un circuit de protection au démarrage 26, connecté entre le transistor 18 et l'interrupteur principal 16, le circuit de protection au démarrage 26 étant configuré pour commander un basculement du transistor 18 à l'état bloqué suite à un passage de l'interrupteur principal 16 en configuration de fermeture, ou suite à une perte de tension de la source électrique 4, suivie d'une réapparition de tension après un délai, l'interrupteur principal 16 restant à l'état passant.

Avantageusement, le circuit de protection au démarrage 26 effectue la commande de basculement du transistor 18 au démarrage à très bref délai, entre 100ns et 100µs, avant l'écoulement de la durée de démarrage du module de contrôle 24 qui est de l'ordre de 1ms. Ainsi, avantageusement, le basculement du transistor est effectué suffisamment rapidement avant que le courant le traversant ne dépasse une valeur prédéterminée, par exemple la valeur d'intensité maximale supportée par le transistor, et donc l'endommagement éventuel du transistor en cas de surintensité est évité. Après écoulement de la durée de démarrage, le module de contrôle 24 prend le relais de commande du transistor 18.

Le dispositif de commutation 10 comporte en outre une diode 28, dont la cathode est connectée en entrée de l'interrupteur principal, et l'anode est connectée à la deuxième borne de sortie 14b, et un condensateur 30 connecté entre la première borne d'entrée 12a et la deuxième borne d'entrée 12b. Les éléments 28 et 30 forment un circuit de protection du JFET 18 lors de son ouverture. D'autres implémentations d'un circuit de protection du JFET 18 sont envisageables, par exemple la connexion en parallèle d'un élément de protection tel qu'une varistance à oxyde métallique (MOV) ou une diode TVS (pour « Transient Voltage Suppression »).

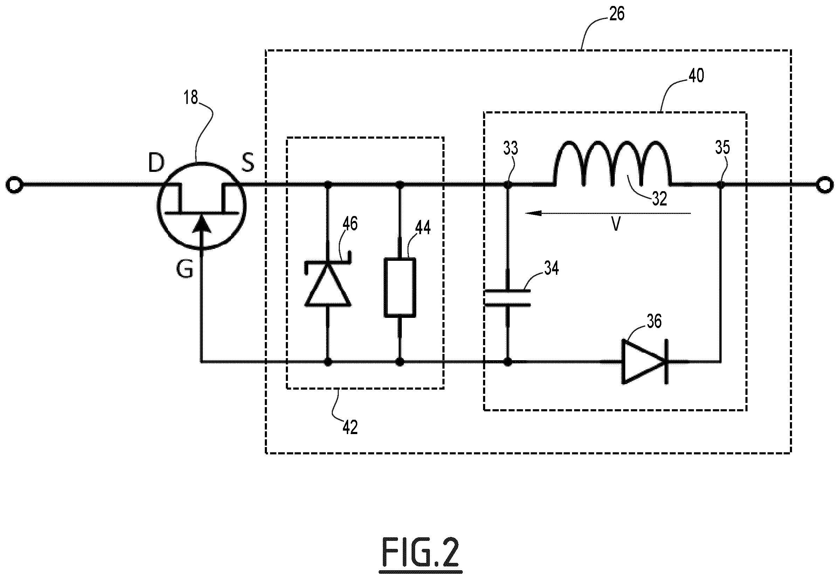

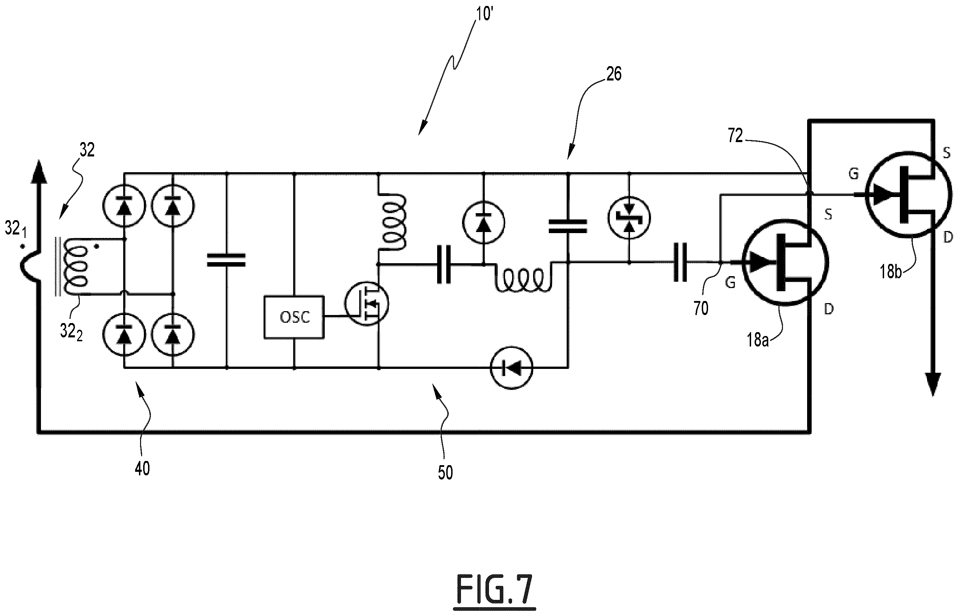

Plusieurs modes de réalisation du circuit de protection au démarrage 26 sont décrits ci-après, d'une part pour un dispositif de commutation monodirectionnel, comme représenté dans les figures 2 à 6 d'autre part pour un dispositif de commutation bidirectionnel comme représenté dans les figures 7 à 13.

Dans un premier mode de réalisation, décrit en référence à la figure 2, le circuit de protection au démarrage 26 pour dispositif de commutation monodirectionnel comporte un premier bloc de protection 40 comportant un composant inductif 32, connecté entre un premier point de connexion 33 et un deuxième point de connexion 35, le premier point de connexion 33 étant connecté à la source S du transistor 18. Le premier bloc de protection 40 génère une tension de commande appliquée à l'électrode de commande G du transistor 18.

Dans ce premier mode de réalisation, le composant inductif 32 est une bobine d'inductance L choisie.

Le premier bloc de protection 40 du circuit de protection au démarrage 26 comporte également un composant capacitif 34 et une diode 36. Le composant capacitif 34 qui stocke l'énergie générée par le composant inductif 32 est connecté entre le premier point de connexion 33 du composant inductif et l'électrode de commande G du transistor 18.

La diode 36 est connectée entre le deuxième point de connexion 35 du composant inductif et l'électrode de commande G (i.e. la grille) du transistor, la cathode de la diode 36 étant connectée au deuxième point de connexion 35 du composant inductif 32, et l'anode de la diode 36 étant connectée à l'électrode de commande G du transistor. Ainsi, la diode 36 est configurée pour bloquer un courant passant du deuxième point de connexion 35 de composant inductif vers l'électrode de commande du transistor.

Une tension de commande V est alors envoyée sur l'électrode de commande du transistor 18 lorsqu'il y a une variation de courant dl/dt positive non nulle du courant dans le composant inductif 32.

Le premier bloc de protection 40 assure une protection du transistor 18 en cas de survenue d'une forte variation de courant sur une durée temporelle courte, en particulier en présence d'un court-circuit au niveau de la charge.

Un dimensionnement adéquat du composant inductif 32 est prévu pour obtenir la génération d'une tension de commande pour un niveau prédéterminé de variation de courant. Par exemple, le composant 32 est une bobine ayant une inductance supérieure ou égale à 1µH, ce qui permet, avec une rampe de courant de 10A par microseconde (µs), d'obtenir une tension de 10 Volt aux bornes du composant inductif 32, cette tension étant suffisante pour commander une ouverture (i.e. un basculement à l'état bloqué) du transistor 18.

Optionnellement, le dispositif de commutation 10 comporte en outre un deuxième bloc de protection 42, comportant une résistance 44 et une diode Zener 46 connectées en parallèle entre l'électrode de commande G du transistor 18 et la source S du transistor 18. Ce deuxième bloc de protection 42 a pour effet de décharger et/ou limiter la tension sur l'électrode de commande G du transistor 18.

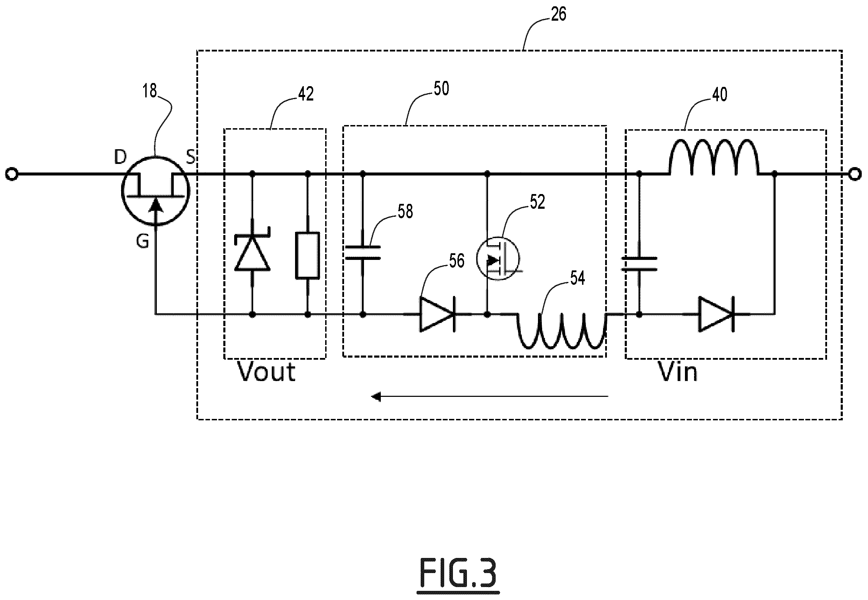

Dans un deuxième mode de réalisation, décrit en référence à la figure 3, le circuit de protection au démarrage 26 comporte le premier bloc de protection 40, optionnellement le deuxième bloc de protection 42 et comporte également un troisième bloc de protection 50.

Ainsi, selon des variantes, le circuit de protection au démarrage 26 comporte soit le premier bloc de protection 40 seulement, soit le premier bloc de protection 40 et le deuxième bloc de protection 42, soit le premier bloc de protection 40 et le troisième bloc de protection 50, soit l'ensemble des premier, deuxième et troisième blocs de protection.

Le troisième bloc de protection 50 est un convertisseur de tension continu-continu (également appelé DC-DC) à découpage, qui est configuré pour convertir une tension continue d'entrée en une tension continue de sortie de valeur différente, et plus particulièrement dans le circuit de protection au démarrage 26, de convertir une tension négative d'entrée en une tension continue négative de sortie, la tension continue négative de sortie ayant une valeur absolue supérieure à une valeur absolue de la tension négative continue d'entrée.

Dans le mode de réalisation illustré à la figure 3, le convertisseur de tension 50 est un convertisseur de type Boost, connecté entre le premier bloc de protection 40 et le deuxième bloc de protection 42.

Dans le mode de réalisation de la figure 3, le convertisseur de tension 50 est un convertisseur élévateur de tension comprenant un commutateur de puissance 52, par exemple un transistor à effet de champ de type MOSFET, une inductance 54, une diode 56 et une capacité 58. La diode 56 et l'inductance 54 sont connectées en série, la capacité 58 est connectée entre l'anode de la diode 56 et la source S du transistor JFET 18, et le commutateur de puissance 52 est connecté en parallèle de la capacité 58, entre la cathode de la diode 56 et la source S du transistor JFET 18.

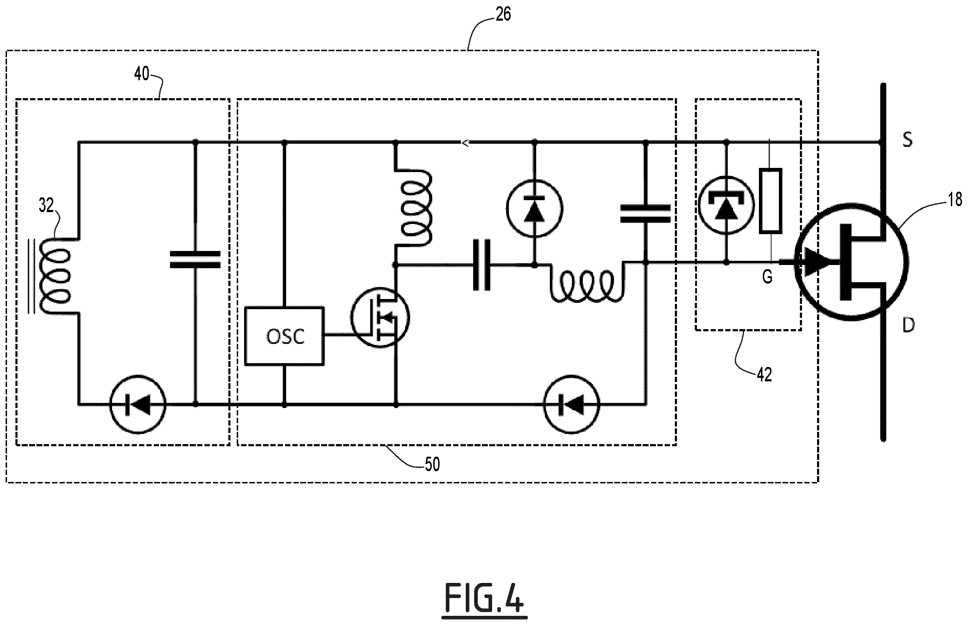

Selon une variante avantageuse, le convertisseur de tension 50 est un convertisseur de type ZETA, comme illustré dans la figure 4. En effet, un convertisseur de type ZETA présente de meilleures performances pour l'amplification négative.

De manière connue, un convertisseur ZETA est un convertisseur de tension DC-DC, non isolé, qui peut être utilisé en mode élévateur ou en mode abaisseur de tension.

Le convertisseur ZETA comporte notamment un oscillateur OSC qui génère un signal d'horloge de rapport cyclique d'environ 50% et de fréquence réglée typiquement entre 100kHz et 10MHz.

Selon des variantes, le convertisseur de tension 50 est un convertisseur DC-DC de Ćuk, un convertisseur « buck-boost » classique ou un convertisseur SEPIC (pour « Single Ended Primary Inductor Converter »).

Avantageusement, l'ajout d'un convertisseur de tension 50 permet de transformer la tension fournie par le premier bloc de protection 40, qui est par exemple une tension négative de l'ordre de -2 Volt en une tension de l'ordre de -10 Volt, qui est suffisante pour ouvrir (i.e. basculer à l'état bloqué) le transistor JFET. En d'autres termes, la tension générée est une tension négative supérieure en valeur absolue à la tension de seuil Vgsₜₕ du transistor JFET 18.

En outre, dans le mode de réalisation de la figure 4, le composant inductif 32 est un transformateur. Avantageusement, l'utilisation d'un transformateur permet d'obtenir plus de tension qu'avec une bobine pour une même valeur de variation de courant, tout en ayant des pertes par conduction plus faibles.

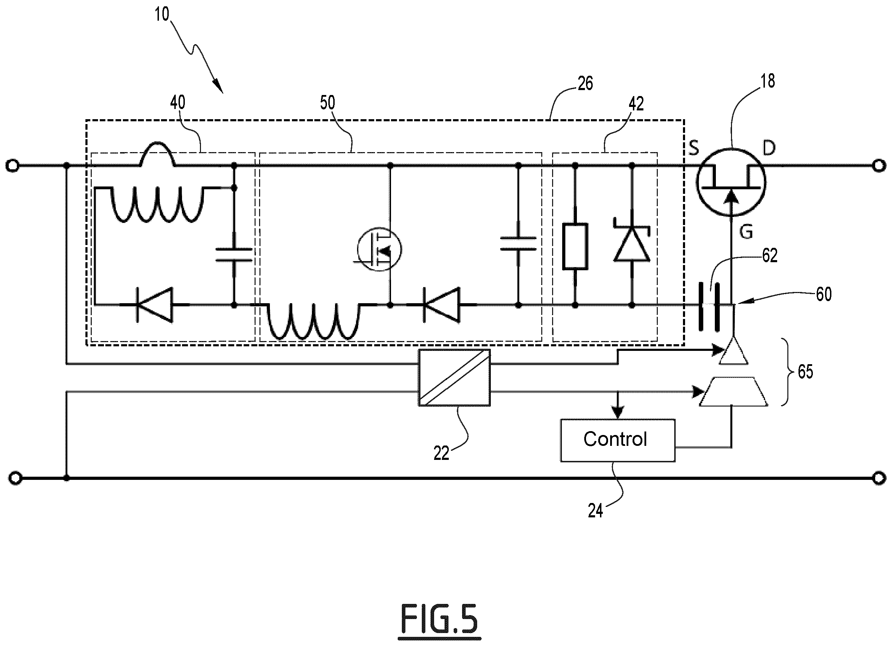

La figure 5 illustre un mode de réalisation d'un dispositif de commutation électrique 10 monodirectionnel, comportant un commutateur à semi-conducteurs 18 de type JFET et un circuit de protection au démarrage 26 tel que décrit ci-dessus.

Le dispositif de commutation électrique 10 comporte en outre un circuit de séparation 60, permettant d'assurer une séparation de la commande du transistor JFET entre le circuit de protection au démarrage et le module de contrôle. En d'autres termes, le circuit de séparation 60 permet d'assurer que la commande du transistor JFET est effectuée par le circuit de protection au démarrage 26 dans un premier temps, pendant une durée de démarrage, par exemple suivant la fermeture de l'interrupteur principal, puis que la commande du transistor JFET est effectuée par le module de contrôle 24 par la suite.

Par exemple, il est prévu que le module de contrôle 24 commande la grille du transistor 18 à environ 1ms après la fermeture de l'interrupteur principal, la durée de démarrage étant alors de l'ordre de 1 ms.

Dans le mode de réalisation de la figure 5, le circuit de séparation 60 est réalisé au moyen d'un condensateur 62, dit condensateur de séparation, qui est connecté en série entre le circuit de protection au démarrage 26 et l'électrode de commande (i.e. la grille G) du transistor 18.

Au démarrage, le condensateur de séparation 62 est déchargé, et tant que le condensateur de séparation est déchargé, la commande du transistor 18 est effectuée par le circuit de protection au démarrage 26 par transmission de la tension de commande à l'électrode de commande G du transistor. La capacité du condensateur de séparation 62 est choisie en fonction d'une durée de démarrage prévue, par exemple de l'ordre de 1 ms.

Après démarrage, l'alimentation auxiliaire 22 alimente le module de contrôle 24, qui est en connexion à basse impédance avec l'électrode de commande G, et effectue la commande du transistor via un circuit 65 de commande de grille isolé, qui est connu de l'homme du métier et n'est pas détaillé ici.

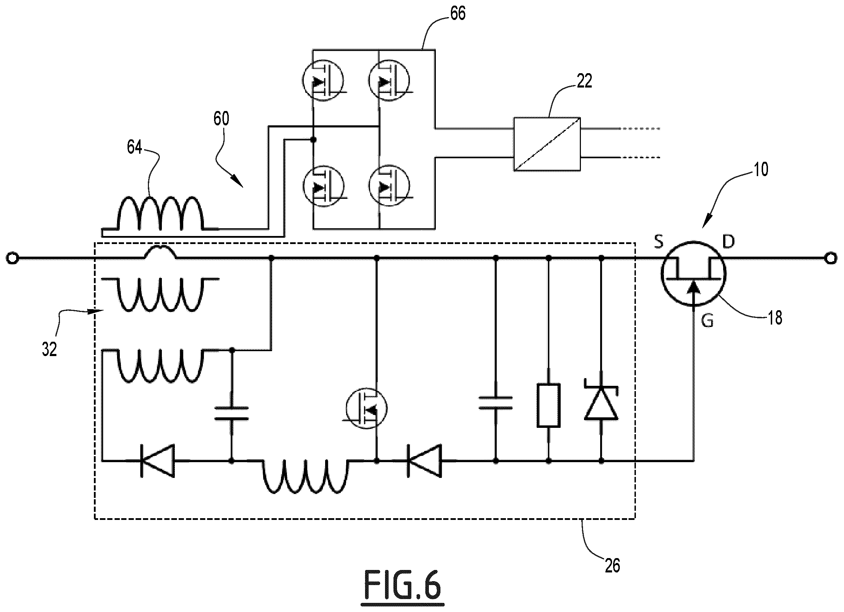

Dans un autre mode de réalisation, illustré à la figure 6, le dispositif de commutation 10 comporte un circuit de protection au démarrage 26 dans lequel le composant inductif 32 est un transformateur, et le circuit de séparation 60, qui a pour fonction d'assurer que pendant une durée de démarrage, le circuit de protection au démarrage 26 est mis en œuvre pour commander le transistor 18, et qu'après la durée de démarrage, le module de contrôle 26 contrôle le transistor 18 ; est réalisé par ajout d'un enroulement 64 au transformateur 32 et d'un pont de commutateurs 66, connectés en H, connecté à l'alimentation électrique auxiliaire 22.

Le pont de commutateurs 66 est par exemple formé de commutateurs MOSFET à haute fréquence de commutation.

Au démarrage, le circuit de protection au démarrage 26 est utilisé pour la protection du transistor 18, comme expliqué ci-dessus. Pour commander le transistor 18 en position passante, au moins deux commutateur MOSFET du pont de commutateurs 66 sont commander pour court-circuiter l'enroulement 64. Pour commander le transistor 18 en position bloquée, un courant pulsé de l'ordre de quelques kilohertz est envoyé dans l'enroulement 64 à l'aide des commutateurs MOSFET du pont de commutateurs 66.

Ainsi, le dispositif de commutation 10 est configuré pour mettre en œuvre le procédé de commutation suivant :
- avant démarrage, l'interrupteur principal est ouvert, et le commutateur à semi-conducteurs, qui est un transistor JFET, est passant ;
- au démarrage, suite à la fermeture de l'interrupteur principal, le premier bloc de protection 40 du circuit de protection au démarrage 26, ou optionnellement le premier bloc de protection 40 combiné au deuxième bloc de protection 42, fournit une tension proportionnelle à la dérivée du courant dl/dt induite dans le composant inductif ;
- optionnellement, lorsque le circuit de protection au démarrage 26 comprend un convertisseur de tension 50, le convertisseur de tension 50 fournit une tension de commande négative de valeur absolue supérieure au seuil entre 10 µs et 10 ms après démarrage, permettant de basculer le JFET à l'état bloqué rapidement et de maintenir le transistor JFET à l'état bloqué pendant une durée de démarrage, la durée de démarrage étant la durée de démarrage (ou mise en fonctionnement) du module de contrôle ;
- après l'écoulement d'une durée de démarrage, entre 1ms et 10ms, le module de contrôle 24 commande le transistor JFET, la commande étant une commande de fermeture (état passant) en l'absence de défaut électrique détecté.

L'invention a été décrite ci-dessus en référence aux figures 1 à 6 pour un dispositif de commutation monodirectionnel à un transistor.

Bien entendu, l'invention s'applique pour des configurations de dispositif de commutation à plusieurs commutateurs à semi-conducteurs, par exemple à deux commutateurs à semi-conducteurs disposés tête-bêche pour réaliser un blocage bidirectionnel. De manière générale, il est envisageable de mettre des semi-conducteurs en parallèle pour tenir plus de courant, ou en série (dans le même sens) pour tenir plus de tension.

Par exemple, comme illustré à la figure 7, dans un premier mode de réalisation d'un dispositif de commutation 10' à 2 transistors, un même circuit de protection au démarrage 26 est utilisé pour la commande des électrodes de commande de deux transistors 18a, 18b, lorsque les électrodes de commande de chacun des transistors 18a, 18b sont connectées en un même noeud de connexion 70. Le composant inductif 32 du circuit de protection au démarrage est un transformateur, comportant un premier enroulement 32, connecté au drain du transistor 18a, et un deuxième enroulement 32₂ connecté aux points milieu d'un pont de diodes 74 Le premier enroulement 32, comporte un premier nombre de spires N1, le deuxième enroulement 32₂ un deuxième nombre de spires N2, et N1 est bien inférieur à N2, le rapport étant par exemple supérieur à 20.

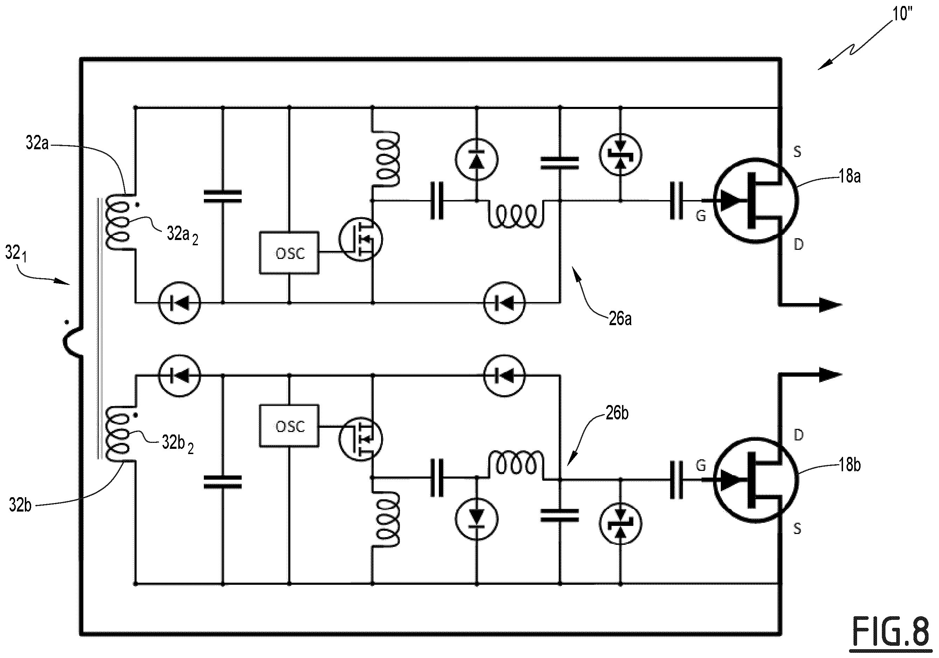

Comme illustré à la figure 8, dans un deuxième mode de réalisation, un dispositif de commutation 10" à 2 transistors 18a, 18b, connectés via leurs électrodes « source » S, chaque transistor 18a, 18b a un circuit de protection au démarrage 26a, 26b associé pour la commande des électrodes de commande G des transistors respectifs 18a, 18b, au démarrage. Dans le mode de réalisation de la figure 8, chaque circuit de protection au démarrage comporte un composant inductif respectif 32a, 32b de type transformateur. Les deux composants inductifs 32a, 32b partagent un enroulement primaire 32, commun, connecté entre les électrodes « source » respectives des transformateurs 18a, 18b, et comportent chacun un enroulement secondaire 32a₂, 32b₂ distinct. L'enroulement primaire 32, comporte de préférence moins de spires que chacun des enroulements secondaires 32a₂, 32b₂.

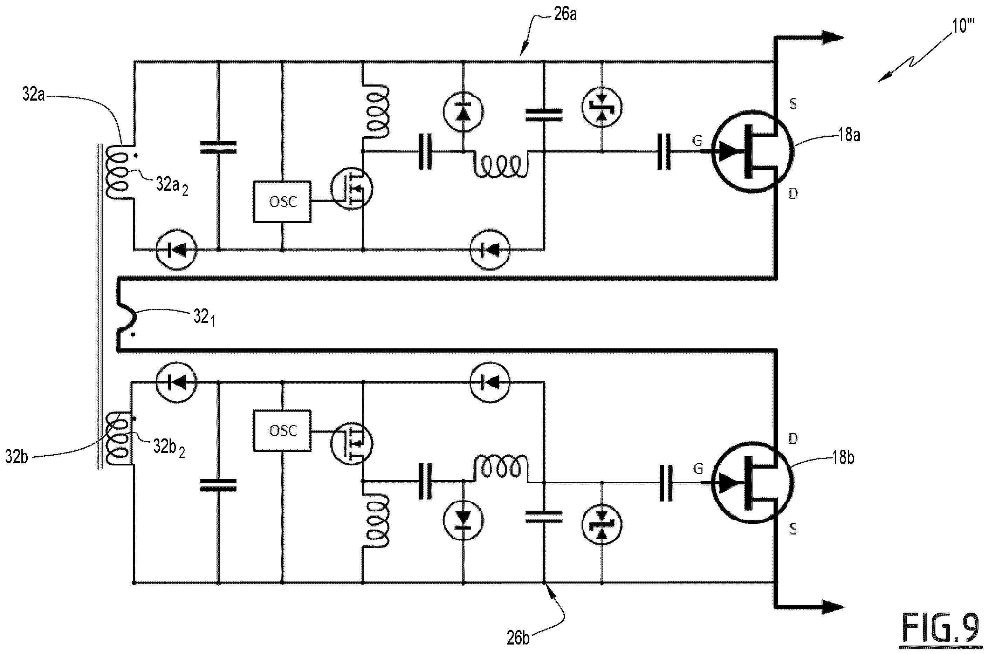

Comme illustré à la figure 9, dans un troisième mode de réalisation d'un dispositif de commutation 10‴ à 2 transistors 18a, 18b, connectés via leurs électrodes « drain » D, chaque transistor 18a, 18b a un circuit de protection au démarrage 26a, 26b associé pour la commande des électrodes de commande au démarrage. Dans le mode de réalisation de la figure 9, chaque circuit de protection au démarrage comporte un composant inductif respectif 32a, 32b de type transformateur, les deux composants inductifs 32a, 32b, comportant chacun un enroulement secondaire 32a₂, 32b₂ distinct, et partageant un enroulement primaire 32, commun connecté entre les électrodes « drain » respectives des transformateurs 18a, 18b. L'enroulement primaire 32, comporte de préférence moins de spires que chacun des enroulements secondaires

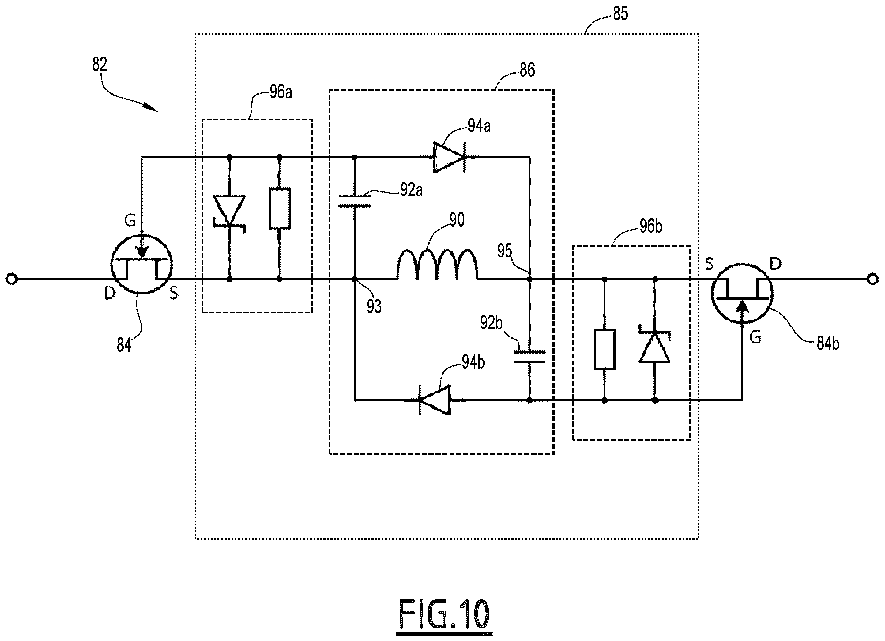

Les figures 10 à 13 illustrent d'autres modes de réalisation de dispositifs de commutation bidirectionnels à commutateurs à semi-conducteurs, comportant deux commutateurs de type JFET connectés tête-bêche.

La figure 10 illustre un schéma électrique d'une partie 82 d'un quatrième mode de réalisation d'un dispositif de commutation bidirectionnel, comportant deux commutateurs à semi-conducteurs de type JFET 84a, 84b, et un circuit de protection au démarrage 85 qui est configuré pour commander respectivement les électrodes de commande (ou de grille) de chacun des transistors 84a, 84b.

Dans le mode de réalisation illustré, qui est similaire au mode de réalisation du dispositif de commutation monodirectionnel illustré dans la figure 2, mais appliqué dans le cas d'un dispositif de commutation bidirectionnel, le circuit de protection au démarrage 85 comporte un premier bloc de protection 86, comportant un composant inductif 90, deux composants capacitifs 92a, 92b et deux diodes 94a, 94b.

Le composant inductif 90 est connecté entre un point de connexion 93 et un deuxième point de connexion 95. Le premier point de connexion 93 est connecté à la source S du transistor 84a, le deuxième point de connexion 95 est connecté à la source S du transistor 84b. Dans ce mode de réalisation, le composant inductif 90 est une bobine d'inductance L choisie.

Le composant capacitif 92a est connecté entre l'anode de la diode 94a et le premier point de connexion 93 du composant inductif 90. La diode 94a est connectée entre le deuxième point de connexion 95 du composant inductif et l'électrode de commande G du transistor 84a, la cathode de la diode 94a étant connectée au deuxième point de connexion 95 du composant inductif 90, et l'anode de la diode 94a étant connectée à l'électrode de commande G du transistor 84a.

Une tension de commande est alors envoyée sur l'électrode de commande G du transistor 84a lorsqu'il y a une variation de courant dl/dt positive non nulle dans le composant inductif 90.

Le composant capacitif 92b est connecté entre l'anode de la diode 94b et le deuxième point de connexion 95 du composant inductif 90. La diode 94b est connectée entre le premier point de connexion 93 du composant inductif et l'électrode de commande G du transistor 84b, la cathode de la diode 94b étant connectée au premier point de connexion 93 du composant inductif 90, et l'anode de la diode 94b étant connectée à l'électrode de commande G du transistor 84b.

Une tension de commande est alors envoyée sur l'électrode de commande G du transistor 84b lorsqu'il y a une variation de courant positive non nulle dl/dt dans le composant inductif 90.

Optionnellement, selon une variante, représentée dans la figure 10, le circuit de protection au démarrage 85 comporte également deux deuxièmes blocs de protection 96a, 96b, chacun des deuxièmes blocs de protection étant similaire au deuxième bloc de protection 42 et comportant respectivement une résistance et une diode Zener connectées en parallèle.

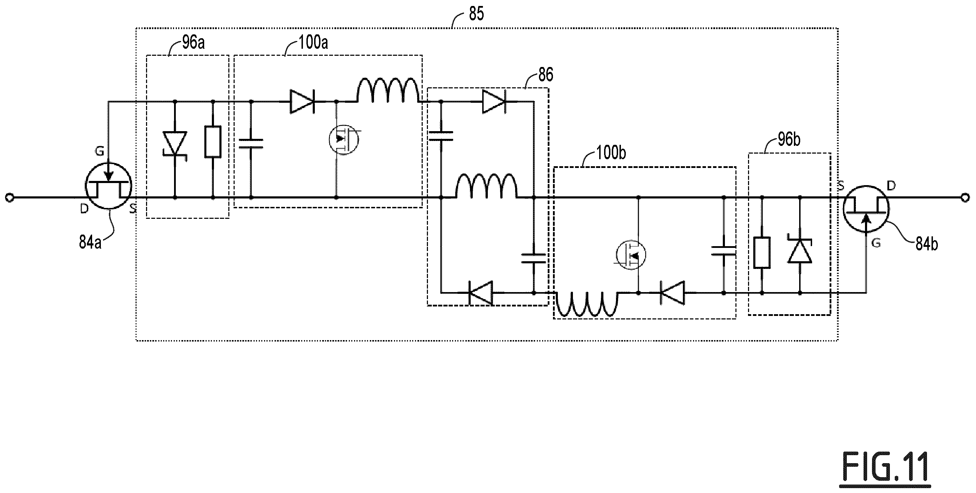

Un cinquième mode de réalisation du circuit de protection au démarrage 85 d'un dispositif de commutation bidirectionnel est illustré en référence à la figure 11. Dans ce mode de réalisation, à l'instar du mode de réalisation illustré dans la figure 3, le circuit de protection au démarrage 85 comprend en outre deux troisièmes blocs de protection 100a, 100b, similaires au troisième bloc de protection 50. Chaque troisième bloc de protection 100a, 100b est, dans ce mode de réalisation, un convertisseur de tension continu-continu à découpage, qui est configuré pour convertir une tension continue d'entrée en une tension continue de sortie de valeur différente, et plus particulièrement dans le circuit de protection 85, une tension négative d'entrée en une tension continue négative de sortie, la tension continue négative de sortie ayant une valeur absolue supérieure à une valeur absolue de la tension négative continue d'entrée.

Le convertisseur de tension 100a est connecté entre le premier bloc de protection 86 et le deuxième bloc de protection 96a, et est configuré pour augmenter, en valeur absolue, la tension de commande de l'électrode de commande du premier transistor 84a.

Le convertisseur de tension 100b est connecté entre le premier bloc de protection 86 et le deuxième bloc de protection 96b, et est configuré pour augmenter, en valeur absolue, la tension de commande de l'électrode de commande du deuxième transistor 84b.

Selon une variante non représentée, chacun des troisièmes blocs de protection 100a, 100b est réalisé sous forme d'un convertisseur de tension de type Zeta.

Selon d'autres variantes non représentées, chacun des troisièmes blocs de protection 100a, 100b est réalisé sous forme d'un convertisseur DC-DC de Ćuk, un convertisseur « buck-boost » classique ou un convertisseur SEPIC (pour « Single Ended Primary Inductor Converter »).

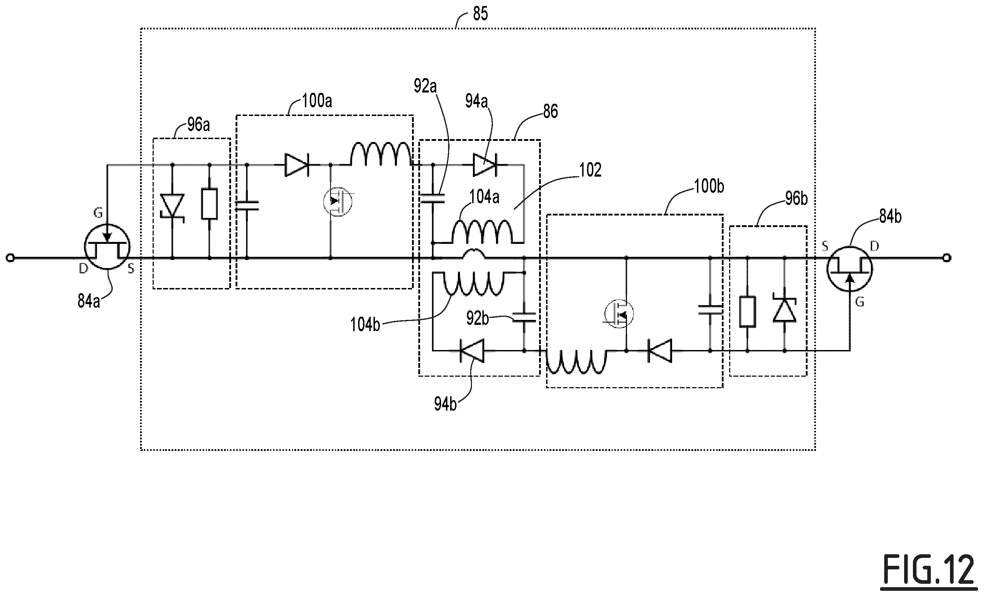

Une variante du mode de réalisation du circuit de protection au démarrage 85 d'un dispositif de commutation bidirectionnel est illustrée à la figure 12. Dans cette variante, le composant inductif du premier bloc de protection 86 est un transformateur 102, comportant deux enroulements 104a, 104b, un premier enroulement 104a étant connecté entre la cathode de la diode 94a et la source S du transistor 84a, et un deuxième enroulement 104b étant connecté entre la cathode de la diode 94b et la source S du transistor 84b.

Il est clair, pour un homme du métier, que de même que dans le cas d'un dispositif de commutation monodirectionnel, un circuit de séparation est ajouté dans un dispositif de commutation bidirectionnel comportant un circuit de protection au démarrage tel que décrit ci-dessus, afin d'assurer que la commande des transistors JFET est effectuée par la circuit de protection au démarrage 85 dans un premier temps suivant la fermeture de l'interrupteur principal, puis que la commande des transistors JFET est effectuée par le module de contrôle 24 par la suite.

De même que dans le cas du dispositif de commutation monodirectionnel, un tel circuit de séparation est réalisable sous diverses formes, par exemple sous forme de composants capacitifs connectés en série ou sous forme de pont de commutateurs connecté à un transformateur supplémentaire.

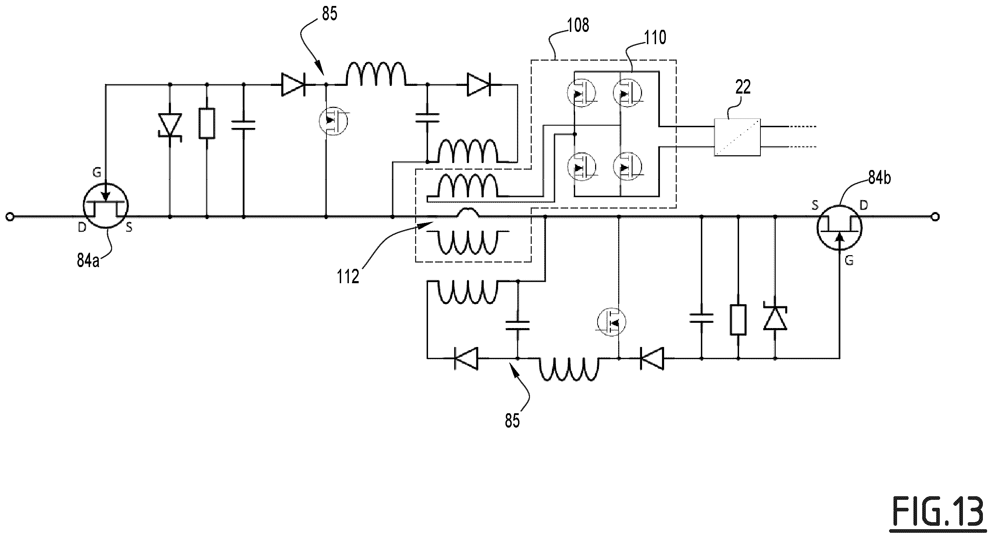

La figure 13 illustre un mode de réalisation un dispositif de commutation bidirectionnel comportant un circuit de protection au démarrage 85 et un circuit de séparation 108 comportant un pont de commutateurs 110 et un transformateur 112.

Le pont de commutateurs 110 est par exemple formé de 4 commutateurs MOSFET configurés pour commuter à haute fréquence.

Le fonctionnement du circuit de séparation 108 est analogue au fonctionnement du circuit de séparation 60 décrit en référence à la figure 6, pour réaliser la commande des transistors 84a, 84b au démarrage par le circuit de protection au démarrage 85, puis la commande des transistors 84a, 84b par le module de contrôle (non représenté) après l'écoulement de la durée de démarrage et la mise en fonctionnement du module de contrôle.

Avantageusement, l'ajout d'un circuit de protection au démarrage tel que décrit permet d'utiliser des commutateurs à semi-conducteur de type JFET dans un dispositif de commutation à semi-conducteurs, de manière sécurisée, en limitant tout risque d'endommagement en cas de démarrage en présence d'un défaut électrique dans l'installation électrique dans laquelle est connecté le dispositif de commutation.

## Revendications

1. Dispositif de commutation électrique à semi-conducteurs, configuré pour être connecté entre une source d'énergie électrique (4) et une charge (6), comportant un interrupteur principal (16) configuré pour basculer dans une configuration d'ouverture dans laquelle la source (4) et la charge (6) sont isolées l'une de l'autre, et dans une configuration de fermeture, dans laquelle la source (4) et la charge (6) sont connectées l'une à l'autre,
- au moins un transistor à effet de champ de type JFET (18, 18a, 18b, 84a, 84b), connecté entre la source (4) et l'interrupteur principal (16), comportant deux électrodes principales (D, S) et une électrode de commande (G), et adapté pour basculer, sur commande de tension sur ladite électrode de commande (G), entre un état passant et un état bloqué et vice versa,
- un module de contrôle (24), connecté entre la source (4) et la charge (6), configuré pour commander ledit au moins un transistor (18, 18a, 18b, 84a, 84b), par application d'une tension de commande sur l'électrode de commande du transistor,
**caractérisé en ce qu'**il comporte en outre un circuit de protection au démarrage (26, 85), connecté audit au moins un transistor, le circuit de protection au démarrage (26, 85) étant configuré pour commander un basculement dudit au moins un transistor (18, 18a, 18b, 84a, 84b) à l'état bloqué, le circuit de protection au démarrage (26, 85) comportant un premier bloc de protection (40, 86) comportant un composant inductif (32, 90), le premier bloc de protection (40, 86) étant adapté pour générer une tension de commande lorsqu'une variation de courant traverse ledit bloc de protection, la tension de commande étant appliquée à l'électrode de commande dudit au moins un transistor (18, 18a, 18b, 84a, 84b).

2. Dispositif selon la revendication 1, dans lequel le premier bloc de protection (40) comporte, pour un transistor à effet de champ de type JFET, un composant capacitif (34) connecté entre un premier point de connexion (33) du composant inductif (32) et l'électrode de commande (G) dudit transistor (18), le premier point de connexion (33) du composant inductif (32) étant connecté à une électrode principale (S) dudit transistor (18), et une diode (36) connectée entre un deuxième point de connexion (35) du composant inductif (32) et l'électrode de commande (G) du transistor (18), la diode étant configurée pour bloquer un courant passant dudit deuxième point de connexion du composant inductif (32) vers l'électrode de commande dudit transistor.

3. Dispositif selon la revendication 1, comportant un premier (84a) et un deuxième (84b) transistor à effet de champ de type JFET, dans lequel ledit premier bloc de protection (86) comporte, un premier composant capacitif (92a) connecté entre un premier point de connexion (93) du composant inductif (90) et l'électrode de commande (G) dudit premier transistor (84a), le premier point de connexion (93) du composant inductif (90) étant connecté à une électrode principale (S) dudit premier transistor (84a), et une diode (94a) connectée entre un deuxième point de connexion (95) du composant inductif (90) et l'électrode de commande (G) du premier transistor (84a), et comporte un deuxième composant capacitif (92b) connecté entre le deuxième point de connexion (95) du composant inductif (90) et l'électrode de commande (G) dudit deuxième transistor (84b), le deuxième point de connexion (95) du composant inductif (90) étant connecté à une électrode principale (S) dudit deuxième transistor (84b), et une diode (94b) connectée entre le premier point de connexion (93) du composant inductif (90) et l'électrode de commande (G) du deuxième transistor (84b).

4. Dispositif selon l'une quelconque des revendications 1 à 3, dans lequel ledit composant inductif (32) est une bobine d'inductance choisie.

5. Dispositif selon l'une quelconque des revendications 1 à 3, dans lequel ledit composant inductif (32) est un transformateur, comportant un enroulement primaire et un enroulement secondaire, l'enroulement primaire dudit transformateur étant connecté à une électrode principale d'au moins un desdits transistors, l'enroulement secondaire étant connecté à ladite diode du premier bloc de protection, l'enroulement primaire comportant un premier nombre de spires, l'enroulement secondaire comportant un second nombre de spires, le premier nombre de spires étant inférieur au second nombre de spires.

6. Dispositif selon l'une quelconque des revendications 1 à 5, dans lequel le circuit de protection au démarrage (26, 85) comporte, pour au moins un transistor à effet de champ de type JFET, un deuxième bloc de protection (42, 96a, 96b), connecté entre une électrode principale dudit transistor et l'électrode de commande dudit transistor.

7. Dispositif selon l'une quelconque des revendications 1 à 6, comportant en outre, pour au moins un transistor à effet de champ de type JFET, un troisième bloc de protection (50, 100a, 100b) associé, ledit troisième bloc de protection (50) étant un convertisseur de tension (50, 100a, 100b) configuré pour convertir une tension continue négative d'entrée en une tension continue négative de sortie, la tension continue négative de sortie ayant une valeur absolue supérieure à une valeur absolue de la tension négative continue d'entrée, ledit convertisseur de tension étant connecté entre ladite électrode principale et l'électrode de commande dudit transistor, ladite tension négative de sortie étant appliqué sur l'électrode de commande dudit transistor.

8. Dispositif selon la revendication 7, dans lequel ledit convertisseur de tension (50, 100a, 100b) est un convertisseur ZETA.

9. Dispositif selon l'une quelconque des revendications 1 à 8, comportant en outre un circuit de séparation (60), configuré pour mettre en fonctionnement le circuit de protection au démarrage(26, 85), pendant une durée de démarrage, de manière à permettre la commande dudit au moins un transistor à effet de champ de type JFET par le circuit de protection au démarrage (26, 85) pendant une durée de démarrage, puis une commande dudit au moins un transistor à effet de champ de type JFET par le module de contrôle (24) après ladite durée de démarrage.

10. Dispositif selon la revendication 9, dans lequel ledit circuit de séparation (60) comporte un condensateur de séparation (62) connecté entre une alimentation auxiliaire (22) dudit module de contrôle (24) et le circuit de contrôle au démarrage (26).

11. Dispositif selon la revendication 9, dans lequel ledit composant capacitif (32, 90) du premier bloc de protection du circuit de protection au démarrage (26, 85) est un transformateur (32) comportant un premier et un deuxième enroulement de spires, ledit circuit de séparation comporte un pont de commutateurs (66) et un troisième enroulement de spires (64) ajouté audit transformateur, le troisième enroulement de spires (64) étant connecté entre des points milieu du pont de commutateurs (66).
